# FASCICULE DE BREVET EUROPEEN

(11) **EP 0 597 746 B1**
(45) Date de publication et mention de la délivrance du brevet: **07.01.1998**
(21) Numéro de dépôt: 93402583.4
(22) Date de dépôt: 21.10.1993
(51) Int. Cl.: G01R 31/28

(54) **Appareil de contrôle pour prise de courant à contact de terre et protection différentielle**
Prüfgerät für Steckdose mit Erdung und Differentialschutz
Test device for electrical socket with earth contact and differential protection

(30) Priorité: 23.10.1992 FR 9212906
(43) Date de publication de la demande: 18.05.1994
(73) Titulaire: SOCIETE ANONYME DES ETS CATU, F-92220 Bagneux (FR)
(72) Inventeur: Bouchez, Bernard, F-92220 Bagneux (FR); Fougassies, Jean-Louis, F-92160 Antony (FR); Monteillet, Philippe, F-94270 Le Kremlin Bicetre (FR)
(74) Mandataire: CABINET BONNET-THIRION

(56) Documents cités:
- DE-A- 3 421 829
- US-A- 3 898 557

## Description

La présente invention concerne d'une manière générale le contrôle de conformité des prises de courant que peut comporter une quelconque installation électrique.

Elle vise plus particulièrement le cas où, suivant des dispositions normatives, une telle prise de courant, et, plus exactement, le socle de cette prise de courant, c'est-à-dire la partie fixe sur laquelle peut être branché par une fiche mobile un quelconque appareil électrique, comporte un contact de terre et est protégé en amont par un quelconque dispositif de protection différentielle, qu'il s'agisse par exemple d'un disjoncteur différentiel ou d'un simple interrupteur différentiel.

Globalement, dans les installations électriques les plus classiques, un tel socle de prise de courant comporte trois contacts, à savoir deux contacts de pôle et un contact de terre.

Les deux contacts de pôle sont usuellement des alvéoles ; l'un d'eux est relié à la phase du réseau électrique correspondant, et l'autre au neutre de celui-ci.

Le contact de terre est usuellement soit une broche soit un ensemble de deux languettes disposées latéralement en positions diamétralement opposées l'une par rapport à l'autre ; il est relié à la terre.

Il importe, notamment, de pouvoir contrôler que le dispositif de protection différentielle disposé en amont est en mesure d'assumer sa fonction qui, pour l'essentiel, est d'assurer, par son déclenchement, une mise hors circuit du socle de prise de courant concerné si, lors du branchement d'un appareil électrique sur celui-ci, il apparaît, entre la phase et la terre, une fuite de courant dangereuse pour l'usager.

Il a déjà été proposé, pour ce faire, des appareils propres à envoyer de manière fugitive entre la phase et la terre une impulsion de défaut comparable à une fuite de courant, en créant ainsi de manière artificielle les conditions conduisant normalement à un déclenchement du dispositif de protection différentielle à contrôler.

Mais, outre que, pour certains au moins, ces appareils sont relativement complexes et coûteux parce qu'il s'agit plus de réels appareils de mesure, aptes par exemple à mesurer la résistance de terre ou le temps de réponse du dispositif de protection différentielle, que de simples appareils de contrôle, les appareils de ce type connus à ce jour ont en commun de ne pas assurer par eux-mêmes une localisation positive de la phase par rapport au neutre.

Or si, de manière classique, dans les socles de prise de courant, la phase est généralement câblée à droite et le neutre à gauche, c'est-à-dire si, usuellement, c'est le contact de pôle le plus à droite d'un tel socle de prise de courant qui est normalement raccordé à la phase du réseau électrique concerné et le contact de pôle le plus à gauche au neutre de celui-ci, il peut arriver que, au câblage, une interversion soit intervenue.

Dans un tel cas, l'envoi d'une impulsion de défaut sur ce qui est présumé être le contact de pôle correspondant à la phase mais se trouve être le contact de pôle correspondant au neutre reste évidemment sans effet.

Il faut, au mieux, avec certains appareils, lorsqu'ils le permettent, procéder une scrutation systématique de l'un et de l'autre des contacts de pôle pour obtenir le résultat recherché.

En outre, dans certains des appareils déjà connus, l'envoi d'une impulsion de défaut intervient systématiquement au bout d'un temps déterminé, sans que l'opérateur ait en quoi que ce soit la maîtrise de cet envoi.

La présente invention a pour objet un appareil de contrôle exempt de ces inconvénients.

Cet appareil de contrôle comporte, en combinaison, des organes de connexion propres à son branchement sur les contacts de pôle et de terre du socle d'une prise de courant, un dispositif indicateur de phase propre à situer géométriquement la phase par rapport aux contacts de pôle de ce socle de prise de courant et comportant deux moyens de visualisation, à raison d'un par contact de pôle, et, piloté par un organe de commande à la disposition de l'usager, et un dispositif d'essai propre à envoyer une impulsion de défaut en orientant systématiquement celle-ci sur l'organe de connexion correspondant à celui des contacts de pôle qui est le contact de phase, et en pratique sur lui seul, pour le contrôle de la capacité de déclenchement du dispositif de protection différentielle placé en amont.

En bref, l'appareil de contrôle suivant l'invention assure systématiquement, par lui-même, préalablement à l'envoi d'une impulsion de défaut, une localisation positive de la phase sur le socle de prise de courant sur lequel il est branché, et il oriente ensuite par lui-même systématiquement cette impulsion de défaut sur le contact de pôle de ce socle de prise de courant auquel la phase est câblée.

Ainsi, que, sur le socle de prise de courant contrôlé, la phase soit correctement câblée à droite ou qu'elle soit malencontreusement câblée à gauche, l'impulsion de défaut arrive toujours entre cette phase et la terre, ce qui permet effectivement de contrôler immédiatement, sans autre manipulation, la capacité de déclenchement du dispositif de protection différentielle placé en amont.

Certes, il est décrit, dans le document US-A-3 898 557, un appareil de contrôle permettant de vérifier le câblage avant tout essai.

Mais il y est expressément indiqué qu'aucun essai ne peut ensuite intervenir avant une correction éventuelle de ce câblage.

Il n'y a donc pas, avec cet appareil de contrôle, une orientation systématique de l'impulsion de défaut sur le contact de phase après localisation de ce dernier.

Autrement dit, cet appareil de contrôle ne permet pas de procéder consécutivement, et sans intervention sur les connexions, à la localisation de la phase et au test de protection différentielle.

Le document DE-A- 3 421 829 divulgue un appareil de mesure, dont le déroulement des opérations effectuées se fait automatiquement. En effet le bouton poussoir coulissant a pour fonction de permettre simplement l'exécution de l'ensemble des opérations de mesure recherchées, en assurant, suivant sa position, soit une alimentation temporaire, soit une alimentation forcée de l'appareil, sans provoquer lui-même l'émission d'une impulsion de défaut. L'opérateur n'a donc pas la maîtrise du moment où intervient effectivement l'émission d'une impulsion de défaut, cette émission intervenant automatiquement au cours du processus déclenché par son action sur ce bouton poussoir coulissant.

Il n'en est pas de même avec l'appareil de contrôle suivant l'invention.

En pratique, pour l'orientation recherchée pour l'impulsion de défaut, il est établi, suivant l'invention, entre le dispositif indicateur de phase et le dispositif d'essai, une liaison de remise à zéro, qui inhibe normalement, en le bloquant, le dispositif d'essai, et ne le libère, en le débloquant, que lorsque la phase a été dûment détectée, soit que, dans une version monovoie simplifiée, à inversion manuelle d'un contact de pôle à l'autre, cette détection n'intervienne que lorsque le contact de pôle auquel est câblée la phase est dûment concerné, soit que, dans une forme de réalisation bivoie automatique, cette détection intervienne systématiquement mais reste sans effet pour celui des contacts de pôle auquel est câblé le neutre.

Quoi qu'il en soit, l'appareil de contrôle suivant l'invention permet avantageusement d'assurer à coup sûr le contrôle recherché chaque fois qu'il est branché sur un socle de prise de courant.

En outre, il ne procède à l'envoi d'une impulsion de courant que sur une action positive de l'opérateur, ce qui laisse à celui-ci la maîtrise de cet envoi.

Enfin, s'agissant d'un appareil de contrôle, qui assure qualitativement le contrôle recherché, sans procéder quantitativement à une quelconque mesure, il est avantageusement relativement économique à fabriquer et simple à utiliser.

Les caractéristiques et avantages de l'invention ressortiront d'ailleurs de la description qui va suivre, à titre d'exemple, en référence aux dessins schématiques annexés sur lesquels :
la figure 1 est une vue en perspective d'un appareil de contrôle suivant l'invention et d'un socle de prise de courant à contrôler ;
la figure 2 est, à échelle supérieure, une vue de bout de l'appareil de contrôle suivant l'invention, suivant la flèche II de la figure 1 ;
la figure 3 en est le schéma constructif ;
la figure 4 est un chronogramme illustrant son fonctionnement ;
la figure 5 est un schéma se rapportant à une variante de réalisation.

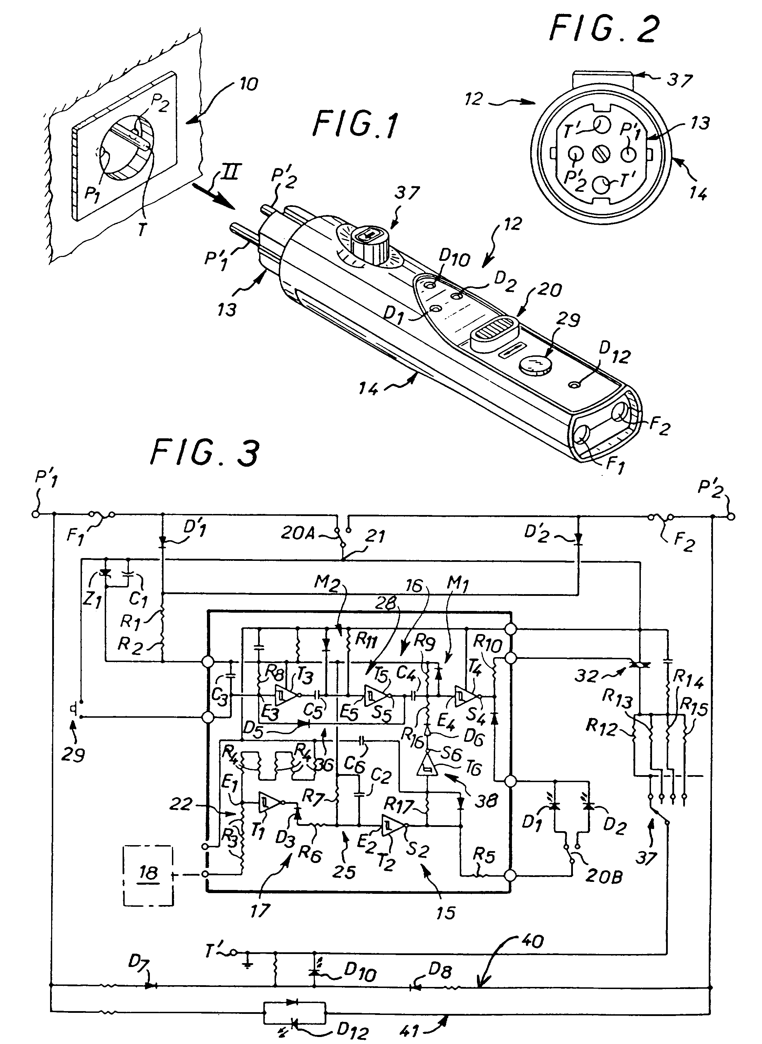

Tel qu'illustré à la figure 1, il s'agit, globalement d'assurer le contrôle d'une prise de courant, et, plus précisément, du socle 10 d'une telle prise de courant, qui, d'une part, comporte, outre des contacts de pôle P1, P2, un contact de terre T, et qui, d'autre part, est protégé en amont par un dispositif de protection différentielle non représenté.

De manière usuelle, les contacts de pôle P1, P2 sont des alvéoles, et, dans la forme de réalisation représentée, le contact de terre T est une broche.

L'appareil de contrôle 12 suivant l'invention comporte des organes de connexion P'1, P'2 et T' propres à son branchement sur ces contacts de pôle P1, P2 et sur ce contact de terre T.

Dans la forme de réalisation représentée, ces organes de connexion P'1, P'2 et T' sont des contacts complémentaires de ceux P1, P2 et T du socle de prise de courant 10, et ils appartiennent conjointement à une fiche 13 propre à être embrochée sur ce dernier.

Les organes de connexion P'1, P'2 sont donc des broches, et l'organe de connexion T' un alvéole.

Dans la forme de réalisation représentée, la fiche 13 n'est pas détrompée, et elle comporte donc, à distance l'un de l'autre, et symétriquement de part et d'autre de l'alignement des organes de connexion P'1, P'2, deux organes de connexion T', figure 2.

En outre, dans cette forme de réalisation, la fiche 13 est solidaire du boîtier 14 que comporte l'appareil de contrôle 12, en formant avec ce boîtier 14 un ensemble monobloc.

Cet appareil de contrôle 12 est ainsi avantageusement manipulable d'une seule main.

Il est entendu cependant que, nonobstant cet aspect monobloc, le boîtier 14 peut être, et est effectivement, réalisé en une ou deux pièces, et, par exemple, en deux coquilles.

En pratique, la fiche 13 intervient frontalement, en bout du boîtier 14.

Ainsi qu'il ressort du schéma de la figure 3, l'appareil de contrôle 12 suivant l'invention comporte, globalement, et en combinaison, dans son boîtier 14, un dispositif indicateur de phase 15, propre à situer géométriquement la phase par rapport aux contacts de pôle P1, P2 du socle de prise de courant 10, et un dispositif d'essai 16 propre à envoyer une impulsion de défaut en orientant systématiquement celle-ci sur l'organe de connexion P'1, P'2 correspondant à celui de ces contacts de pôle P1, P2 qui est le contact de phase, pour le contrôle de la capacité de déclenchement du dispositif de protection différentielle placé en amont.

Le dispositif indicateur de phase 15 comporte, lui-même, globalement, deux moyens de visualisation D1, D2, en pratique des diodes électroluminescentes de couleur rouge, qui, à raison d'un par contact de pôle P1, P2, et en liaison avec un circuit de détection 17 détaillé ultérieurement, sont établis chacun respectivement en parallèle entre un organe de couplage 18 propre à une liaison capacitive avec la terre et les deux organes de connexion P'1, P'2 correspondant aux deux contacts de pôles P1, P2.

Dans la forme de réalisation plus particulièrement représentée sur les figures 1 à 4, l'appareil de contrôle 12 est un appareil monovoie à inversion manuelle.

Il ne comporte donc qu'un seul circuit de détection 17 et qu'un seul organe de couplage 18 pour les organes de connexion P'1, P'2, et donc pour les deux moyens de visualisation D1, D2, avec, à la disposition de l'usager, sur le boîtier 14, un inverseur 20 permettant de passer de l'un à l'autre.

En pratique, cet inverseur 20 commande simultanément deux contacts 20A, 20B.

Le contact 20A concerne les organes de connexion P'1, P'2.

Son point central 21 constitue, pour l'ensemble, un point de référence supposé être à un potentiel nul.

L'alimentation de l'ensemble est assurée alternativement à partir de l'organe de connexion P'1 ou de l'organe de connexion P'2 par l'intermédiaire de ce même contact 20A.

Elle se fait par l'intermédiaire de fusibles temporisés F1, F2, et, après un redressement monoalternance assuré par des diodes d'orientation D'1, D'2, et intervention de résistances de limitation de courant communes R1, R2, elle est dûment régulée par une diode Zener Z1 et dûment filtrée par un condensateur C1.

La tension d'alimentation correspondante est par exemple de l'ordre de 6,2 V.

Le contact 20B commandé par l'inverseur 20 concerne les moyens de visualisation D1, D2.

Les diodes électroluminescentes constituant ces moyens de visualisation D1, D2 sont présentes en façade sur le boîtier 14.

Elles y occupent géométriquement une position qui est à l'image de celle des contacts de pôle P1, P2 sur le socle de prise de courant 10.

En pratique, l'organe de couplage 18 est un organe métallique, tel qu'une plaque ou un simple clinquant, qui, disposé dans le boîtier 14, et donc non visible sur les figures, forme contrepoids.

Dans la forme de réalisation représentée, le circuit de détection 17 du dispositif indicateur de phase 15 comporte, en série, à compter de l'organe de couplage 18, un pont diviseur 22, qui est formé, d'une part, de résistances R3, et, d'autre part, de résistances R4, à chaque fois en nombre voulu, et dont l'extrémité opposée à l'organe de couplage 18 est reliée au point de référence 21, un détecteur de niveau T1, dont l'entrée E1 est reliée au point milieu du pont diviseur 22, et un intégrateur 25.

Si nécessaire, et tel que représenté, il comporte en outre, en aval de l'intégrateur 25, un inverseur logique T2, dont la sortie S2 est reliée, par l'intermédiaire d'une résistance de limitation de courant R5, au point central du contact 20B de l'inverseur 20.

Préférentiellement, le détecteur de niveau T1 et l'inverseur logique T2 sont constitués par des triggers de SCHMITT, pour une meilleure qualité des signaux.

De manière usuelle, l'intégrateur 25 est formé d'un réseau de résistances R6, R7 et d'un condensateur C2.

Dans la forme de réalisation représentée, cet intégrateur 25 est précédé d'une diode d'orientation D3 destinée à empêcher une éventuelle décharge du condensateur C2 du côté basse impédance.

Le dispositif d'essai 16, quant à lui, comporte, globalement, entre chacun des organes de connexion P'1, P'2 correspondant aux contacts de pôle P1, P2 et l'organe de connexion T' correspondant au contact de terre T, un circuit de commande 28, qui, pour l'élaboration d'une impulsion de défaut D, est piloté par un organe de commande 29 à la disposition de l'usager.

Dans la forme de réalisation représentée, cet organe de commande 29 est un bouton-poussoir.

Mais, en variante, cet organe de commande 29 pourrait tout aussi bien être une touche sensitive, non représentée.

Sa constitution est alors analogue à celle de l'organe de couplage 18, avec, conjointement, une mise en oeuvre, à pont diviseur, du même type.

Globalement, le circuit de commande 28 du dispositif d'essai 16 comporte, en série, à compter de l'organe de commande 29, un inverseur logique T3, dont l'entrée E3 est antiparasitée par un réseau de filtrage formé d'un condensateur C3 et d'une résistance R8 montés en parallèle, un monostable de commande M1, qui est formé d'un condensateur C4 et d'une résistance R9, et qui est temporisé à une valeur t1 correspondant à la durée souhaitée pour l'impulsion de défaut D, et, au-delà d'une résistance de limitation de courant R10, un commutateur de charge 32, qui est interposé entre le point de référence 21 et l'organe de connexion T', et qui, en pratique, est constitué par un triac.

Dans la forme de réalisation représentée, ce circuit de commande 28 comporte, en outre, entre l'inverseur logique T3 et le monostable de commande M1, un monostable de verrouillage M2, qui, comme le monostable de commande M1, est formé d'un condensateur C5 et d'une résistance R11, et qui est temporisé à une valeur t2 multiple de celle t1 à laquelle est temporisé ce monostable de commande M1.

Par exemple, si le monostable de commande M1 est temporisé à une valeur t1 égale à 150 ms, le monostable de verrouillage M2 peut être temporisé à une valeur t2 de l'ordre de 1,8 à 2 s.

Mais, bien entendu, ces valeurs numériques ne sont données ici qu'à titre indicatif sans qu'il puisse en résulter une quelconque limitation de l'invention.

En pratique, dans la forme de réalisation représentée, le monostable de commande M1 est sous le contrôle d'un inverseur logique T4, et, de même, le monostable de verrouillage M2 est sous le contrôle d'un inverseur logique T5, avec, pour le verrouillage recherché, un bouclage de réaction 36 qui, établi entre la sortie S5 de l'inverseur logique T5 et l'entrée E3 de l'inverseur logique T3, comporte une diode d'orientation D5.

Comme précédemment, les inverseurs logiques T3, T4 et T5 sont préférentiellement des triggers de SCHMITT, pour une meilleure qualité des signaux.

Dans la forme de réalisation représentée, le circuit de commande 28 du dispositif d'essai 16 comporte, en outre, en aval du commutateur de charge 32, une pluralité de résistances de puissance R12, R13, R14, R15 ... etc... disposées en parallèle sous le contrôle d'un sélecteur de gamme 37, qui, présent en façade sur le boîtier 14, est à la disposition de l'usager.

Suivant l'invention, une liaison de remise à zéro 38 est établie entre le dispositif indicateur de phase 15 et le dispositif d'essai 16 ainsi constitués.

Dans la forme de réalisation représentée, cette liaison de remise à zéro 38 intervient entre la sortie S2 de l'inverseur logique T2 du dispositif indicateur de phase 15 et l'entrée E4 de l'inverseur logique T4 du dispositif d'essai 16, et elle comporte, en série, un inverseur logique T6, une diode d'orientation D6, et une résistance de limitation de courant R16.

Comme précédemment, l'inverseur logique T6 est préférentiellement constitué par un trigger de SCHMITT, pour une meilleure qualité des signaux.

Il contrôle la charge d'un condensateur C6, qui, en série avec une résistance R17, est établi entre le pont diviseur 22 du circuit de détection 17 du dispositif indicateur de phase 15 et la sortie de ce circuit de détection 17, en parallèle vis-à-vis du détecteur de niveau T1, de l'intégrateur 25, et, éventuellement, de l'inverseur logique T2, que comporte celui-ci.

Par ailleurs, dans la forme de réalisation représentée, les organes de connexion P'1, P'2 correspondant aux contacts de pôle P1, P2 sont reliés conjointement, en parallèle l'un par rapport à l'autre, et en parallèle vis-à-vis du dispositif indicateur de phase 15 et du dispositif d'essai 16, à l'organe de connexion T' correspondant au contact de terre T, par une liaison 40, comportant, pour un contrôle d'un bon raccordement à la terre de ce contact de terre T, outre des diodes d'orientation D7, D8, un moyen de visualisation D10.

Comme précédemment, ce moyen de visualisation D10 est constitué par une diode électroluminescente, par exemple de couleur verte, présente en façade du boîtier 14.

En pratique, cette diode électroluminescente est disposée en triangle avec les diodes électroluminescentes constituant les moyens de visualisation D1, D2 associés chacun respectivement aux contacts de pôle P1, P2.

Enfin, les organes de connexion P'1, P'2 correspondant aux contacts de pôle P1, P2 sont également reliés entre eux, en parallèle vis-à-vis du dispositif indicateur de phase 15 et du dispositif d'essai 16, par une liaison 41 comportant, pour un contrôle de la présence d'une tension entre ces contacts de pôle P1, P2, un moyen de visualisation D12.

Comme précédemment, ce moyen de visualisation D12 est constitué par une diode électroluminescente, par exemple de couleur rouge, présente en façade du boîtier 14.

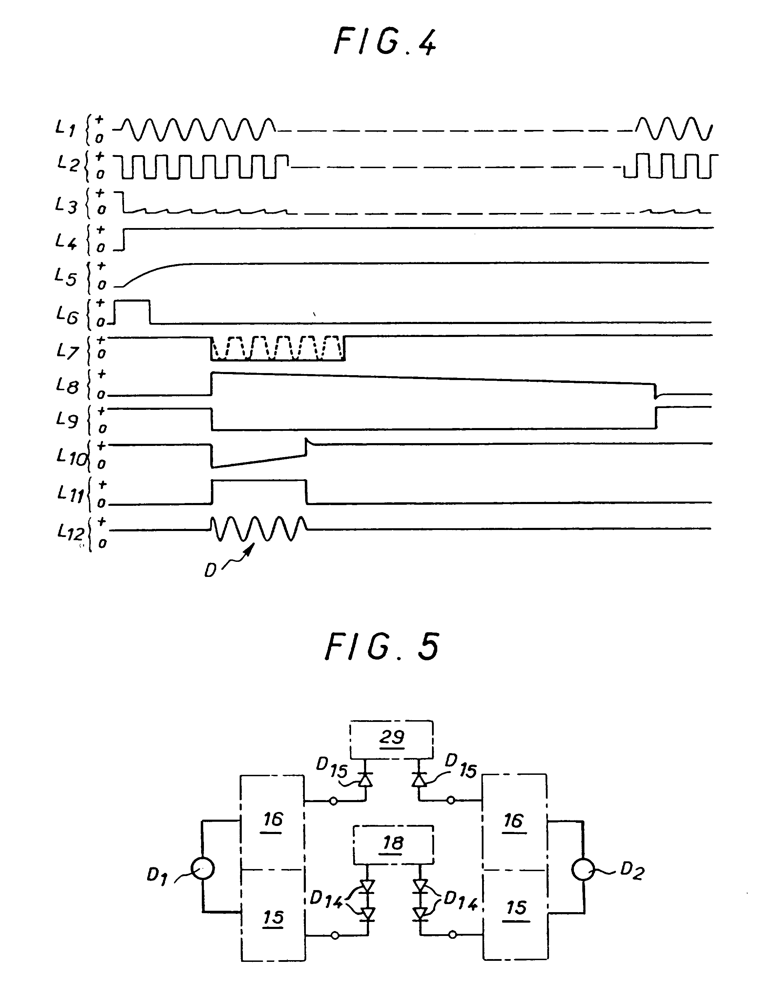

Sur le chronogramme de la figure 4, on a reporté à la ligne L1 la tension à l'entrée El du détecteur de niveau T1 du circuit de détection 17 du dispositif indicateur de phase 15, à la ligne L2 la tension à la sortie S1 de ce détecteur de niveau T1, à la ligne L3 la tension à l'entrée E2 de l'inverseur logique T2, à la ligne L4 la tension à la sortie S2 de cet inverseur logique T2, à la ligne L5 la tension à l'entrée E6 de l'inverseur logique T6 de la liaison de remise à zéro 38, à la ligne L6 la tension à la sortie S6 de cet inverseur logique T6, à la ligne L7 la tension à l'entrée E3 de l'inverseur logique T3 du circuit de commande 28 du dispositif d'essai 16, à la ligne L8 la tension à l'entrée E5 de l'inverseur logique T5 de ce circuit de commande 28, à la ligne L9 la tension à la sortie S5 de cet inverseur logique T5, à la ligne L10 la tension à l'entrée E4 de l'inverseur logique T4 de ce même circuit de commande 28, à la ligne L11 la tension à la sortie S4 de cet inverseur logique T4, et à la ligne L12 la tension représentative de l'impulsion de défaut D.

Dès l'embrochage de l'appareil de contrôle 12 suivant l'invention dans le socle de prise de courant 10 à contrôler, et pourvu que le câblage des contacts de pôle P1, P2 de celui-ci soit correct, avec la phase à droite et le neutre à gauche, un courant circule de la phase à la terre à travers le pont diviseur 22 du circuit de détection 17 du dispositif indicateur de phase 15 et l'organe de couplage 18, si, corollairement, l'inverseur 20 est positionné en conséquence.

Pour des raisons qui apparaîtront ultérieurement, cela se traduit par l'excitation quasi instantanée du moyen de visualisation D2 correspondant, ligne L4 de la figure 4.

S'il n'en est pas ainsi, l'opérateur modifie la position de l'inverseur 20, et c'est alors le moyen de visualisation D1 qui se trouve excité.

Dans l'un et l'autre cas, le fonctionnement, décrit ci-après, de l'appareil de contrôle 12 suivant l'invention est le même.

Le courant de phase détecté, c'est-à-dire le courant circulant comme indiqué entre la phase et la terre, est transformé en tension aux bornes des résistances R4 du pont diviseur 22, ligne L1 de la figure 4.

Il s'agit bien entendu d'une tension alternative.

Après mise en forme par le détecteur de niveau T1, ligne L2 de la figure 4, cette tension est intégrée par l'intégrateur 25, ligne L3 de la figure 4.

Le signal correspondant, qui, à l'état brut, est plus ou moins irrégulier, assure l'excitation du moyen de visualisation D1, D2 concerné, après lissage et inversion par l'inverseur logique T2, ligne L4 de la figure 4.

Corollairement, le dispositif d'essai 16 se trouve temporairement inhibé par la liaison de remise à zéro 38.

En effet, l'entrée E6 de l'inverseur logique T6 de cette liaison de remise à zéro 38 étant initialement au niveau 0, ligne L5 de la figure 4, la sortie S6 de cet inverseur logique T6 se trouve initialement au niveau + correspondant à la tension d'alimentation, ligne L6 de la figure 4, ce qui bloque le monostable de commande M1.

Ainsi, il est évité que, à l'embrochage de l'appareil de contrôle 12 sur le socle de prise de courant 10, une situation aléatoire ne conduise à l'émission prématurée et intempestive d'une quelconque impulsion de défaut.

Mais, au bout d'un temps déterminé t3 correspondant à la charge du condensateur C6 à travers la résistance R17, la tension sur l'entrée E6 de l'inverseur logique T6 est suffisante pour que sa sortie S6 bascule au niveau 0, ligne L6 de la figure 4, ce qui libère le monostable de commande M1.

Après que, suivant le processus précédemment décrit, l'opérateur ait constaté, par l'excitation de l'un ou l'autre des moyens de visualisation D1, D2, que la localisation de la phase était dûment assurée, il peut intervenir sur l'organe de commande 29.

Si, comme indiqué, l'organe de commande 29 est un bouton-poussoir, la tension sur l'entrée E3 de l'inverseur logique T3 du circuit de commande 28 du dispositif d'essai 16 passe brusquement du niveau + au niveau 0, comme indiqué en trait continu à la ligne L7 de la figure 4.

Si l'organe de commande 29 est une touche sensitive, cette tension est une tension alternative, comme indiqué en traits interrompus sur cette ligne L7 de la figure 4.

Mais, dans l'un et l'autre cas, seul est pris en compte le front avant correspondant, quelle que soit la durée d'intervention sur l'organe de commande 29.

Dès cette intervention, la tension à la sortie S3 de l'inverseur logique T3 du circuit de commande 28 du dispositif d'essai 16 bascule du niveau 0 au niveau +, et, par voie de conséquence, il en est de même pour la tension à l'entrée E5 de l'inverseur logique T5, ligne L8 de la figure 4.

Par voie de conséquence, également, la tension à l'entrée E4 de l'inverseur logique T4 bascule du niveau + au niveau 0, ligne L10 de la figure 4, cependant que, corollairement, la tension sur sa sortie S4 bascule elle au contraire du niveau 0 au niveau +, ligne L11 de la figure 4.

Il en résulte, simultanément, d'une part, la mise en conduction du commutateur de charge 32, et, donc, l'émission d'une impulsion de défaut D à travers celui-ci, ligne L12 de la figure 4, et, d'autre part, la désexcitation du moyen de visualisation D1, D2 précédemment excité, un même niveau de tension étant alors présent de part et d'autre de celui-ci.

Ainsi, l'opérateur se trouve avisé de l'envoi effectif de l'impulsion de défaut D.

Mais, corollairement, a débuté la charge du condensateur C4 du monostable de commande M1 à travers la résistance R9.

Au bout du temps t1 prévu à cet effet, cette charge est suffisante pour ramener au niveau + la tension à l'entrée E4 de l'inverseur logique T4, ligne L10 de la figure 4, et donc pour ramener au niveau 0 la tension à la sortie S4 de cet inverseur logique T4, ligne L11 de la figure 4.

Il en résulte, simultanément, d'une part, le blocage du commutateur de charge 32, et, donc, l'arrêt de l'impulsion de défaut D, qui se trouve ainsi dûment calibrée, et, d'autre part, une nouvelle excitation du moyen de visualisation D1, D2 concerné si le dispositif de protection différentielle situé en amont n'a pas déclenché.

Corollairement, également, le basculement du niveau + au niveau 0 de la tension à la sortie S5 de l'inverseur logique T5, ligne L9 de la figure 4, a provoqué, par le bouclage de réaction 36, un retour au niveau 0 de la tension à l'entrée E3 de l'inverseur logique T3, et, par là, un verrouillage de l'ensemble du circuit de commande 28 du dispositif d'essai 16.

Ainsi, toute éventuelle nouvelle intervention sur l'organe de commande 29 demeure sans effet, ce qui évite l'envoi répété d'impulsions de défaut D dans un laps de temps trop court, et minimise donc, d'une part, une éventuelle remontée de potentiel sur la terre, et, d'autre part, une élévation de température des résistances de puissance R12, R13, R14, R15 ... si le dispositif de protection différentielle situé en amont est défectueux.

Le verrouillage du circuit de commande 28 du dispositif d'essai 16 se poursuit pendant toute la charge du condensateur C5 du monostable de verrouillage M2 à travers la résistance R11.

Au terme de cette charge, la tension à la sortie S5 de l'inverseur logique T5 revient au niveau +, ligne L9 de la figure 4, ce qui assure le déverrouillage du circuit de commande 28.

En pratique, la durée de l'impulsion de défaut D, qui, comme indiqué, correspond à la valeur t1 de la temporisation du monostable de commande M1, est supérieure au temps limite de non déclenchement des dispositifs de protection différentielle dits sélectifs, à déclenchement retardé, et au temps de coupure maximal des dispositifs de protection différentielle normaux.

Ainsi, le dispositif de protection différentielle protégeant le socle de prise de courant 10 doit normalement déclencher sur une telle impulsion de défaut D.

Les fusibles temporisés F1, F2 sont temporisés à une valeur légèrement supérieure, de manière à laisser passer cette impulsion de défaut D.

Mais si, par suite par exemple d'une quelconque avarie, la durée de cette impulsion de défaut D se trouvait être supérieure à celle prévue, ils rempliraient alors systématiquement leur fonction.

Bien entendu, il a été supposé, dans ce qui précède, que l'opérateur a, au préalable, positionné le sélecteur de gamme 37 en fonction du calibre du dispositif de protection différentielle à contrôler.

S'il le positionne sur un calibre inférieur, aucun déclenchement n'est observé.

En pratique, les repères de position de ce sélecteur de gamme 37 sont affichés en milliampères, en raison inverse de la valeur des résistances R12, R13, R14, R15 ... etc... correspondantes.

Le schéma de la figure 5 se rapporte à une variante de réalisation bivoie automatique.

Suivant cette variante de réalisation, il y a un dispositif indicateur de phase 15 et un dispositif d'essai 16 pour chacun des organes de connexion P'1, P'2, et donc pour chacun des moyens de visualisation D1, D2.

Par exemple, et tel que représenté, il y a alors un seul organe de couplage 18 pour les deux dispositifs indicateurs de phase 15, avec, par sécurité, entre cet organe de couplage 18 et ces dispositifs indicateurs de phase 15, des diodes d'orientation D14, pour éviter tout retour de l'un à l'autre d'entre eux.

Préférentiellement, ces diodes d'orientation D14 sont des diodes à très faible courant inverse, et, tel que représenté, elles sont doublées, pour diminuer les courants résiduels de fuite correspondants.

De même, il n'y a qu'un seul organe de commande 29 pour les deux dispositifs d'essai 16 dans la variante de réalisation représentée, avec, entre cet organe de commande 29 et ces dispositifs d'essai 16, des diodes d'orientation D15.

Une telle variante de réalisation bivoie automatique scrute simultanément les deux contacts de pôle P1, P2 du socle de prise de courant 10 à contrôler.

Mais, du fait de la liaison de remise à zéro 38 établie, suivant le schéma précédemment décrit, entre chacun des dispositifs indicateurs de phase 15 et le dispositif d'essai 16 correspondant, seul se trouve déverrouillé le dispositif d'essai 16 correspondant au contact de pôle P1, P2 auquel est effectivement câblée la phase, et c'est donc sur ce seul contact de pôle P1, P2 qu'est envoyée une impulsion de défaut D quand il est agi sur l'organe de commande 29.

Suivant une autre variante de réalisation bivoie non représentée, il est prévu un organe de couplage 18, et éventuellement un organe de commande 29, pour chacun des organes de connexion P'1, P'2, et, donc, pour chacun des moyens de visualisation D1, D2.

La présente invention ne se limite d'ailleurs aux formes de réalisation décrites et représentées, mais englobe toute variante d'exécution et/ou de combinaison de leurs divers éléments située dans le cadre des présentes revendications.

## Revendications

1. Appareil de contrôle pour prise de courant à contact de terre et protection différentielle, comportant, en combinaison, des organes de connexion (P'1, P'2, T') propres à son branchement sur les contacts de pôle (P1, P2) et de terre (T) du socle (10) d'une telle prise de courant, un dispositif indicateur de phase (15) propre à situer géométriquement la phase par rapport aux contacts de pôle (P1, P2) de ce socle de prise de courant (10) et comportant deux moyens de visualisation (D1, D2), à raison d'un par contact de pôle (P1, P2), et, piloté par un organe de commande (29) à la disposition de l'usager, un dispositif d'essai (16) propre à envoyer une impulsion de défaut (D) en orientant systématiquement celle-ci sur l'organe de connexion (P'1, P'2) correspondant à celui desdits contacts de pôle (P1, P2) qui est le contact de phase, pour le contrôle de la capacité de déclenchement du dispositif de protection différentielle placé en amont.

2. Appareil de contrôle suivant la revendication 1, caractérisé en ce que, en liaison avec un circuit de détection (17), les deux moyens de visualisation (D1, D2) sont établis chacun respectivement en parallèle entre un organe de couplage (18) propre à une liaison capacitive avec la terre et les deux organes de connexion (P'1, P'2) correspondant aux deux contacts de pôle (P1, P2).

3. Appareil de contrôle suivant la revendication 2, caractérisé en ce que le circuit de détection (17) du dispositif indicateur de phase (15) comporte, en série, à compter de l'organe de couplage (18), un pont diviseur (22), un détecteur de niveau (T1), un intégrateur (25), et, éventuellement, un inverseur logique (T2).

4. Appareil de contrôle suivant l'une quelconque des revendications 2, 3, caractérisé en ce que l'organe de couplage (18) est un organe métallique, tel que plaque, formant contrepoids.

5. Appareil de contrôle suivant l'une quelconque des revendications 1 à 4, caractérisé en ce que le dispositif d'essai (16) comporte, entre chacun des organes de connexion (P'1, P'2) correspondant aux contacts de pôle (P1, P2) et l'organe de connexion (T') correspondant au contact de terre (T), un circuit de commande (28), qui, pour l'élaboration d'une impulsion de défaut (D), est piloté par l'organe de commande (29) à la disposition de l'usager.

6. Appareil de contrôle suivant la revendication 5, caractérisé en ce que le circuit de commande (28) du dispositif d'essai (16) comporte, en série, à compter de l'organe de commande (29), un inverseur logique (T3), un monostable de commande (M1), et un commutateur de charge (32).

7. Appareil de contrôle suivant la revendication 6, caractérisé en ce que le circuit de commande (28) du dispositif d'essai (16) comporte, en outre, entre l'inverseur logique (T3) et le monostable de commande (M1), un monostable de verrouillage (M2) temporisé à une valeur multiple de celle à laquelle est temporisé le monostable de commande (M1).

8. Appareil de contrôle suivant l'une quelconque des revendications 5, 6, caractérisé en ce que le circuit de commande (28) du dispositif d'essai (16) comporte, en outre, en aval du commutateur de charge (32), une pluralité de résistances de puissance (R12, R13, R14, R15...) disposées en parallèle sous le contrôle d'un sélecteur de gamme (37) à la disposition de l'usager.

9. Appareil de contrôle suivant l'une quelconque des revendications 5 à 8, caractérisé en ce que l'organe de commande (28) du dispositif d'essai (16) est un bouton-poussoir.

10. Appareil de contrôle suivant l'une quelconque des revendications 5 à 8, caractérisé en ce que l'organe de commande (29) du dispositif d'essai (16) est une touche sensitive.

11. Appareil de contrôle suivant l'une quelconque des revendications 1 à 10, caractérisé en ce qu'une liaison de remise à zéro (38) est établie entre le dispositif indicateur de phase (15) et le dispositif d'essai (16).

12. Appareil de contrôle suivant les revendications 3 et 11, prises conjointement, caractérisé en ce que la liaison de remise à zéro (38) comporte un inverseur logique (T6) qui contrôle la charge d'un condensateur (C6) établi entre le pont diviseur (22) du circuit de détection (17) du dispositif indicateur de phase (15) et la sortie de ce circuit de détection (17).

13. Appareil de contrôle suivant l'une quelconque des revendications 1 à 12, caractérisé en ce qu'il ne comporte qu'un dispositif indicateur de phase (15) et qu'un dispositif d'essai (16) pour les deux organes de connexion (P'1, P'2) correspondant aux contacts de pôle (P1, P2), avec, à la disposition de l'usager, un inverseur (20) permettant de passer de l'un à l'autre.

14. Appareil de contrôle suivant l'une quelconque des revendications 1 à 12, caractérisé en ce qu'il comporte un dispositif indicateur de phase (15) et un dispositif d'essai (16) pour chacun des organes de connexion (P'1, P'2) correspondant aux contacts de pôle (P1, P2).

15. Appareil de contrôle suivant les revendications 2 et 14, prises conjointement, caractérisé en ce qu'il comporte un seul organe de couplage (18) pour les deux dispositifs indicateurs de phase (15), avec, entre cet organe de couplage (18) et ces dispositifs indicateurs de phase (15), des diodes d'orientation (D14).

16. Appareil de contrôle suivant les revendications 5 et 14, prises conjointement, caractérisé en ce qu'il comporte un seul organe de commande (29) pour les deux dispositifs d'essai (16), avec, entre cet organe de commande (29) et ces dispositifs d'essai (16), des diodes d'orientation (D15).

17. Appareil de contrôle suivant l'une quelconque des revendications 1 à 16, caractérisé en ce que, en parallèle vis-à-vis du ou des dispositifs indicateurs de phase (15) et du ou des dispositifs d'essai (16), les organes de connexion (P'1, P'2) correspondant aux contacts de pôle (P1, P2) sont reliés conjointement à l'organe de connexion (T') correspondant au contact de terre (T) par une liaison (40) comportant un moyen de visualisation (D10).

18. Appareil de contrôle suivant l'une quelconque des revendications 1 à 17, caractérisé en ce que, en parallèle vis-à-vis du ou des dispositifs indicateurs de phase (15) et du ou des dispositifs d'essai (16), les organes de connexion (P'1, P'2) correspondant aux contacts de pôle (P1, P2) sont reliés entre eux par une liaison (41) comportant un moyen de visualisation (D12).

19. Appareil de contrôle suivant l'une quelconque des revendications 17, 18, caractérisé en ce que, deux fusibles temporisés (F1, F2) étant associés chacun respectivement aux organes de connexion (P'1, P'2) correspondant aux contacts de pôle (P1, P2), la liaison (40) entre ces organes de connexion (P'1, P'2) et l'organe de connexion (T') correspondant au contact de terre (T) et/ou la liaison (41) qui les relie entre eux interviennent en amont desdits fusibles (F1, F2).

20. Appareil de contrôle suivant l'une quelconque des revendications 1 à 19, caractérisé en ce que ses organes de connexion (P'1, P'2, T') sont des contacts complémentaires de ceux (P1, P2, T) du socle de prise de courant (10) et appartiennent conjointement à une fiche (13) propre à être embrochée sur ce dernier.

21. Appareil de contrôle suivant la revendication 20, caractérisé en ce que sa fiche (13) est solidaire de son boîtier (14) en formant avec celui-ci un ensemble monobloc.

## Patentansprüche

1. Prüfgerät für Anschlußstelle mit Erdkontakt und Differentialschutz, umfassend in Verbindung miteinander Anschlußeinrichtungen (P'1, P'2, T'), die zu deren Anklemmen an die Pol- (P1, P2) und Erdkontakte (T) der Steckdose (10) einer derartigen Anschlußstelle geeignet sind, eine Phasenanzeigeeinrichtung (15), die geeignet ist, die Phase bezüglich der Polkontakte (P1, P2) dieser Anschlußstellensteckdose (10) geometrisch zu bestimmen, und umfassend zwei Sichtbarmachungsmittel (D1, D2), im Verhältnis von einem pro Polkontakt (P1, P2) und gesteuert durch eine dem Benutzer zur Verfügung stehende Betätigungseinrichtung (29), eine Versuchsvorrichtung (16), die geeignet ist, einen Fehlerimpuls (D) zu senden, wobei dieser systematisch auf die Anschlußeinrichtung (P'1, P'2) zu gerichtet ist, die demjenigen dieser Polkontakte (P1, P2) entspricht, der der Phasenkontakt ist, für die Prüfung der Auslösefähigkeit der stromaufwärts angeordneten Differentialschutzvorrichtung.

2. Prüfgerät nach Anspruch 1, dadurch gekennzeichnet, daß in Verbindung mit einem Detektionsschaltkreis (17) die zwei Sichtbarmachungsmittel (D1, D2) jeweils parallel zwischen einer Kopplungseinrichtung (18), die zu einer kapazitiven Verbindung mit der Erde geeignet ist, und den zwei Anschlußeinrichtungen (P'1, P'2), die den zwei Polkontakten (P1, P2) entsprechen, eingerichtet sind.

3. Prüfgerät nach Anspruch 2, dadurch gekennzeichnet, daß der Detektionsschaltkreis (17) der Phasenanzeigevorrichtung (15) in Reihe von der Kopplungseinrichtung (18) ausgehend einen Brückenteiler (22), einen Niveaudetektor (T1), einen Integrator (25) und eventuell einen logischen Inverter (T2) umfaßt.

4. Prüfgerät nach einem der Ansprüche 2 oder 3, dadurch gekennzeichnet, daß die Kopplungseinrichtung (18) eine Metalleinrichtung, wie eine Platte ist, die Gegengewichte bildet.

5. Prüfgerät nach einem der Ansprüche 1 bis 4, dadurch gekennzeichnet, daß die Versuchsvorrichtung (16) zwischen jeder der Anschlußeinrichtungen (P'1, P'2), die den Polkontakten (P1, P2) entsprechen, und der Anschlußeinrichtung (T'), die dem Erdkontakt (T) entspricht, einen Betätigungsschaltkreis (28) umfaßt, der zur Erzeugung eines Fehlerimpulses (D) durch eine dem Benutzer zur Verfügung stehende Betätigungseinrichtung (29) gesteuert wird.

6. Prüfgerät nach Anspruch 5, dadurch gekennzeichnet, daß der Betätigungsschaltkreis (28) der Versuchsvorrichtung (16) in Reihe, von der Betätigungseinrichtung (29) ausgehend, einen logischen Inverter (T3), eine monostabile Betätigungsstufe (M1) und einen Ladeumschalter (32) umfaßt.

7. Prüfgerät nach Anspruch 6, dadurch gekennzeichnet, daß der Betätigungsschaltkreis (28) der Versuchsvorrichtung (16) außerdem zwischen dem logischen Inverter (T3) und der monostabilen Betätigungsstufe (M1) eine monostabile Verriegelungsstufe (M2) umfaßt, die mit einem mehrfachen Wert von demjenigen verzögert wird, mit dem die monostabile Betätigungsstufe (M1) verzögert wird.

8. Prüfgerät nach einem der Ansprüche 5 oder 6, dadurch gekennzeichnet, daß der Betätigungsschaltkreis (28) der Versuchsvorrichtung (16) außerdem stromabwärts von dem Ladeumschalter (32) eine Vielzahl von Hochbelastungswiderständen (R12, R13, R14, R15...) umfaßt, die parallel unter der Kontrolle eines dem Benutzer zur Verfügung stehenden Bereichsschalters (37) angeordnet sind.

9. Prüfgerät nach einem der Ansprüche 5 bis 8, dadurch gekennzeichnet, daß die Betätigungseinrichtung (28) der Versuchsvorrichtung (16) ein Druckknopf ist.

10. Prüfgerät nach einem der Ansprüche 5 bis 8, dadurch gekennzeichnet, daß die Betätigungseinrichtung (29) der Versuchsvorrichtung (16) eine Sensortaste ist.

11. Prüfgerät nach einem der Ansprüche 1 bis 10, dadurch gekennzeichent, daß eine Nullsetzverbindung (38) zwischen der Phasenanzeigevorrichtung (15) und der Versuchsvorrichtung (16) eingerichtet ist.

12. Prüfgerät nach den Ansprüchen 3 und 11 zusammengenommen, dadurch gekennzeichnet, daß die Nullsetzverbindung (38) einen logischen Inverter (T6) umfaßt, der das Laden eines Kondensators (C6) kontrolliert, der zwischen dem Brückenteiler (22) des Detektionsschaltkreises (17) der Phasenanzeigevorrichtung (15) und dem Ausgang dieses Detektionsschaltkreises (17) eingerichtet ist.

13. Prüfgerät nach einem der Ansprüche 1 bis 12, dadurch gekennzeichnet, daß es nur eine Phasenanzeigevorrichtung (15) und eine Versuchsvorrichtung (16) für die beiden Anschlußeinrichtungen (P'1, P'2), die den Polkontakten (P1,P2) entsprechen, umfaßt mit einem dem Benutzer zur Verfügung stehenden Inverter (20), der es erlaubt, von dem einen zum anderen umzuschalten.

14. Prüfgerät nach einem der Ansprüche 1 bis 12, dadurch gekennzeichnet, daß es eine Phasenanzeigevorrichtung (15) und eine Versuchsvorrichtung (16) für jede der Anschlußeinrichtungen (P'1, P'2), die den Polkontakten (P1,P2) entsprechen, umfaßt.

15. Prüfgerät nach den Ansprüchen 2 und 14 zusammengenommen, dadurch gekennzeichnet, daß es eine einzige Kopplungseinrichtung (18) für die zwei Phasenanzeigevorrichtungen (15) mit Richtdioden (D14) zwischen dieser Kopplungseinrichtung (18) und diesen Phasenanzeigevorrichtungen (15) umfaßt.

16. Prüfgerät nach den Ansprüchen 5 und 14 zusammengenommen, dadurch gekennzeichnet, daß es eine einzige Betätigungseinrichtung (29) für die zwei Versuchsvorrichtungen (16) mit Richtdioden (D15) zwischen dieser Betätigungseinrichtung (29) und diesen Versuchsvorrichtungen (16) umfaßt.

17. Prüfgerät nach einem der Ansprüche 1 bis 16, dadurch gekennzeichnet, daß parallel bezüglich der oder den Phasenanzeigevorrichtungen (15) und der oder den Versuchsvorrichtungen (16) die Anschlußeinrichtungen (P'1, P'2), die den Polkontakten (P1, P2) entsprechen, gemeinsam mit der Anschlußeinrichtung (T'), die dem Erdkontakt (T) entspricht, durch eine Verbindung (40) verbunden sind, die ein Sichtbarmachungsmittel (D10) umfaßt.

18. Prüfgerät nach einem der Ansprüche 1 bis 17, dadurch gekennzeichnet, daß parallel bezüglich der oder den Phasenanzeigevorrichtungen (15) und der oder den Versuchsvorrichtungen (16) die Anschlußeinrichtungen (P'1, P'2), die den Polkontakten (P1, P2) entsprechen, untereinander durch eine Verbindung (41) verbunden sind, die ein Sichtbarmachungsmittel (D12) umfaßt.

19. Prüfgerät nach einem der Ansprüche 17 oder 18, dadurch gekennzeichnet, daß die Verbindung (40) zwischen diesen Anschlußeinrichtungen (P'1, P'2) und der Anschlußeinrichtung (T'), die dem Erdkontakt (T) entspricht und/oder der Verbindung (41), die sie untereinander verbindet, stromaufwärts zweier verzögerter Sicherungen (F1, F2) eingeschaltet ist, wobei diese Sicherungen (F1, F2) jeweils jeder der Anschlußeinrichtungen (P'1, P'2), die den Polkontakten (P1, P2) entsprechen, zugeordnet sind.

20. Prüfgerät nach einem der Ansprüche 1 bis 19, dadurch gekennzeichnet, daß seine Anschlußeinrichtungen (P'1, P'2, T') komplementäre Kontakte zu denen (P1, P2, T) der Steckdose der Anschlußstelle (10) sind und gemeinsam zu einem Stecker (13) gehören, der geeignet ist, an die Letztere gesteckt zu werden.

21. Prüfgerät nach Anspruch 20, dadurch gekennzeichnet, daß sein Stecker (13) mit seinem Gehäuse (14) fest verbunden ist, wobei er mit diesem einen einstückigen Aufbau bildet.

## Claims

1. A testing apparatus for a power connection with an earth contact and differential protection, comprising in combination connecting members (P'1, P'2, T') for connection thereof to the pole contacts (P1, P2) and the earth contact (T) of the plug base (10) of such a power connection, a phase indicator device (15) for geometrically locating the phase with respect to the pole contacts (P2, P2) of said power connection plug base (10) and comprising two display means (D1, D2), with one for each pole contact (P1, P2), and, pilot-controlled by a control member (29) operable by the user, a test arrangement (16) capable of sending a fault pulse (D), systematically orienting same to the connecting member (P'1, P'2) corresponding to that one of said pole contacts (P1, P2) which is the phase contact, for testing the capacity for tripping of the upstream-disposed differential protection device.

2. A testing apparatus according to claim 1 characterised in that in connection with a detection circuit (17) the two display means (D1, D2) are each established respectively in parallel relationship between a coupling member (18) capable of a capacitive connection to earth and the two connecting members (P'1, P'2) corresponding to the two pole contacts (P1, P2).

3. A testing apparatus according to claim 2 characterised in that the detection circuit (17) of the phase indicator device (15) comprises, in series, from the coupling member (18), a divider bridge (22), a level detector (T1), an integrator (25) and possibly a logic inverter (T2).

4. A testing apparatus according to either one of claims 2 and 3 characterised in that the coupling member (18) is a metal member such as a plate forming a counterweight.

5. A testing apparatus according to any one of claims 1 to 4 characterised in that the test arrangement (16) comprises between each of the connecting members (P'1, P'2) corresponding to the pole contacts (P1, P2) and the connecting member (T') corresponding to the earth contact (T) a control circuit (28) which for producing a fault pulse (D) is pilot-controlled by the control member (29) operable by the user.

6. A testing apparatus according to claim 5 characterised in that the control circuit (28) of the test arrangement (16) comprises in series from the control member (29) a logic inverter (T3), a monostable control means (M1) and a charge switch (32).

7. A testing apparatus according to claim 6 characterised in that the control circuit (28) of the test arrangement (16) further comprises between the logic inverter (T3) and the monostable control means (M1) a monostable latching means (M2) time-delayed to a value which is a multiple of that to which the monostable control means (M1) is time-delayed.

8. A testing apparatus according to either one of claims 5 and 6 characterised in that the control circuit (28) of the test arrangement (16) further comprises downstream of the charge switch (32) a plurality of power resistors (R12, R13, R14, R15 ...) disposed in parallel under the control of a range selector (37) operable by the user.

9. A testing apparatus according to any one of claims 5 to 8 characterised in that the control member (28) of the test arrangement (16) is a push button.

10. A testing apparatus according to any one of claims 5 to 8 characterised in that the control member (29) of the test arrangement (16) is a sensitive key.

11. A testing apparatus according to any one of claims 1 to 10 characterised in that a zero-resetting connection (38) is established between the phase indicator device (15) and the test arrangement (16).

12. A testing apparatus according to claims 3 and 11 in combination characterised in that the zero-resetting connection (38) comprises a logic inverter (T6) which controls the charge of a capacitor (C6) between the divider bridge (22) of the detection circuit (17) of the phase indicator device (15) and the output of said detection circuit (17).

13. A testing apparatus according to any one of claims 1 to 12 characterised in that it comprises only one phase indicator device (15) and only one test arrangement (16) for the two connecting members (P'1, P'2) corresponding to the pole contacts (P1, P2), with, operable by the user, an inverter (20) for going from one to the other.

14. A testing apparatus according to any one of claims 1 to 12 characterised in that it comprises a phase indicator device (15) and a test arrangement (16) for each of the connecting members (P'1, P'2) corresponding to the pole contacts (P1, P2).

15. A testing apparatus according to claims 2 and 14 in combination characterised in that it comprises a single coupling member (18) for the two phase indicator devices (15) with orientation diodes (D14) between said coupling member (18) and said phase indicator devices (15).

16. A testing apparatus according to claims 5 and 14 in combination characterised in that it comprises a single control member (29) for the two test arrangements (16) with orientation diodes (D15) between said control member (29) and said test arrangements (16).

17. A testing apparatus according to any one of claims 1 to 16 characterised in that in parallel relationship with respect to the phase indicator device or devices (15) and the test arrangement or arrangements (16) the connecting members (P'1, P'2) corresponding to the pole contacts (P1, P2) are connected jointly to the connecting member (T') corresponding to the earth contact (T) by a connection (40) comprising a display means (D10).

18. A testing apparatus according to any one of claims 1 to 17 characterised in that in parallel relationship with respect to the phase indicator device or devices (15) and the test arrangement or arrangements (16) the connecting members (P'1, P'2) corresponding to the pole contacts (P1, P2) are connected together by a connection (41) comprising a display means (D12).

19. A testing apparatus according to either one of claims 17 and 18 characterised in that two time-delay fuses (F1, F2) each being associated respectively with the connecting members (P'1, P'2) corresponding to the pole contacts (P1, P2), the connection (40) between said connecting members (P'1, P'2) and the connecting member (T') corresponding to the earth contact (T) and/or the connection (41) which connects them together occurs upstream of said fuses (F1, F2).

20. A testing apparatus according to any one of claims 1 to 19 characterised in that its connecting members (P'1, P'2, T') are contacts which are complementary to those (P1, P2, T) of the power connection plug base (10) and belong jointly to a plug portion (13) which is capable of being fitted on to the latter.

21. A testing apparatus according to claim 20 characterised in that its plug portion (13) is fixed with respect to its casing (14), forming therewith a unitary assembly.
